# EUROPEAN PATENT SPECIFICATION

(11) **EP 1 270 193 B1**
(45) Date of publication and mention of the grant of the patent: **22.03.2006**
(21) Application number: 02012380.8
(22) Date of filing: 06.06.2002
(51) Int. Cl.: B30B 15/06, B32B 5/06, B32B 5/26

(54) **Use of a heat resistant cushioning material in a press molding process**
Verwendung eines hitzebeständigen Presspolsters in einem Pressverfahren
Utilisation d'un coussinet résistant à la chaleur dans un procédé de pressage

(30) Priority: 19.06.2001 JP 2001184699; 01.02.2002 JP 2002025244
(43) Date of publication of application: 02.01.2003
(73) Proprietor: ICHIKAWA CO.,LTD., Tokyo (JP)
(72) Inventor: Takamura, Hideyuki, Kashiwa-shi, Chiba-ken (JP)
(74) Representative: Forstmeyer, Dietmar

(56) References cited:
- EP-A- 0 561 158
- EP-A- 0 718 429
- EP-A- 1 084 821
- WO-A-00/57738
- WO-A-00/61508
- GB-A- 986 686
- US-A- 5 863 390
- US-A- 6 162 746
- "USES FOR PBO FIBER" RESEARCH DISCLOSURE, KENNETH MASON PUBLICATIONS, HAMPSHIRE, GB, no. 354, 1 October 1993 (1993-10-01), pages 678-684, XP000412834 ISSN: 0374-4353
- PATENT ABSTRACTS OF JAPAN vol. 1997, no. 07, 31 July 1997 (1997-07-31) & JP 09 072697 A (TOYOBO CO LTD), 18 March 1997 (1997-03-18)
- "IMPROVED LAMINATE BOOK CONSTRUCTION" RESEARCH DISCLOSURE, KENNETH MASON PUBLICATIONS, HAMPSHIRE, GB, no. 333, 1992, page 40 XP000281153 ISSN: 0374-4353
- "PRESSURE PAD FOR HIGH TEMPERATURE LAMINATION" IBM TECHNICAL DISCLOSURE BULLETIN, IBM CORP. NEW YORK, US, vol. 32, no. 12, 1 May 1990 (1990-05-01), pages 162-163, XP000105311 ISSN: 0018-8689

## Description

### [DETAILED DESCRIPTION OF THE INVENTION]

### [Technical Field of the Invention]

The present invention relates to a use of a heat resistant cushioning material for press molding, and more specifically to a use of a high cushion volume heat resistant cushioning material for press molding in the manufacture of laminates for printed wiring boards, printed wiring boards, CSPs, and flat panel displays.

### [Prior Art]

Printed wiring boards are extensively used in the areas where any electric connection is needed including electronic devices. For example, single-sided printed wiring boards, in which a conductive pattern is formed on one side of the board, are used for radios, stereos, microwave ovens, refrigerators, washing machines, and others. Double-sided printed wiring boards, in which a conductive pattern is formed on both sides of the board, are used for facsimiles, word processors, CD players, and others. A multilayer printed wiring board is formed by press molding more than two boards, each of which is formed with a conductive pattern, with a prepreg sandwiched between each pair of the boards, and thus it is a type of printed wiring board which has more than three layers of conductive patterns within the board in addition to those on the outer surfaces of the board. These multilayer printed wiring boards are used in central processing units (CPUs) and/or memory units of super computers, high-grade communication devices or high-speed measuring instruments such as satellite communications apparatuses which require high-density wiring and/or high-density assembly and/or high reliability.

Generally, a printed board used for printed wiring boards includes a paper-phenol laminate consisting of craft paper and phenolic resin or a glass-epoxy laminate consisting of glass fiber fabric and epoxy resin. A heat resistant cushioning material for press molding which is used in the manufacture of the foregoing laminates plays an important role in uniformly distributing heat and pressure over the whole area of the molded prepreg (in a B stage condition) by compensating irregularities, deformations, unevenness of the hot plates and/or the mirror plates of a press molding. That is to say, in a hot-press process, a cushioning material is placed between the hot plate and the metal mirror plate which is placed in contact with the prepreg sheet so that unevenness of temperature on the prepreg sheet due to the piping for the heating medium disposed in the hot plate is corrected and pressure is uniformly distributed over the entire prepreg sheet by supplying a constant amount of heat from the heat platen within a given time while the prepreg sheet gradually hardens after its viscosity is reduced temporarily returning to a liquid state by heating.

In the case of laminates such as glass epoxy laminate, a press molding is generally adopted for mass production in which the raw materials are arranged between the hot plates so that more than ten sheets of the products are produced in a single press cycle. In the case of those laminates, products are manufactured in sizes such as, for example, 1m x 1m, 1m x 2m, and 1m x 4m and the number of hot plates mounted on a press molding is about 11 to 31 depending on individual press machines. These press machines are called such as a 10-stage press or a 30-stage press from the number of the hot plates. A sheet of the product manufactured in a single stage between a pair of hot plates is called as a page, and sometimes all the products formed in a single stage is called altogether as a book. Several to ten-odd sheets of prepregs, of which glass cloth is impregnated with epoxy resin in a semi-cured state, are laminated in a single sheet of the product depending on the thickness of the product. To produce a double-sided printed wiring board, a cupper foil of a thickness of 17 to 70 *µ*m is applied on each side of the laminated prepreg, while the copper foil is applied only on one surface in the case of a single-sided printed wiring board.

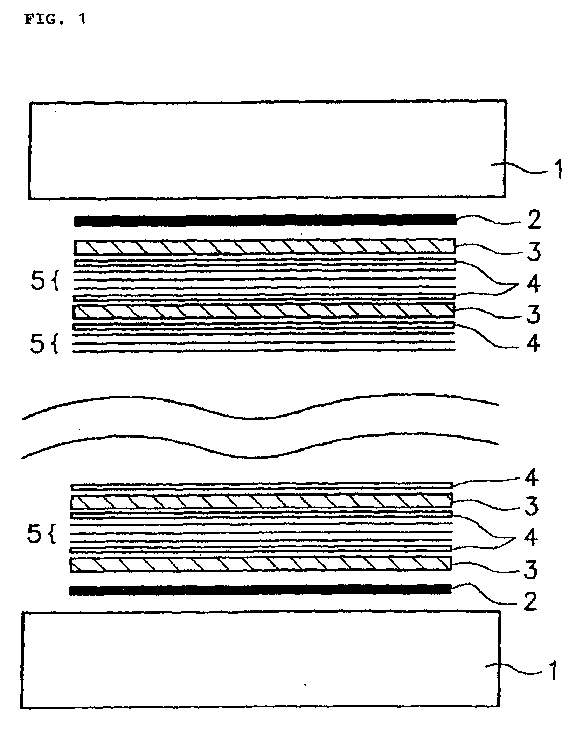

Referring to an example shown in Fig. 1, a book of double-sided printed wiring boards to be set between a pair of hot plates is arranged in such a way from bottom to top as (1) lower hot plate 1 + (2) heat resistant cushioning material 2 + ((3) mirror plate 3 + (4) cupper foil 4 + (5) prepreg sheets 5 of a predetermined number depending on the thickness of the laminated board + (6) copper foil 4) x the number of the pages in a book + (7) mirror plate 3 + (8) heat resistant cushioning material 2 + (9) upper hot plate 1. Thus, when the laminated board is manufactured in a 1m x 1m page and 12 pages in a book using a 20-stage press machine, the number of laminated boards of a 1m x 1m size manufactured in a single press cycle will be 240. But when it is manufactured in a 1m x 4m page and 12 pages in a book using a 30-stage press machine in the same manner as described above, the number of laminated boards converted to a 1m x 1m size will be 1440 thereby increasing the productivity by six times. Therefore, the introduction of a larger scale multi-stage press machine is desired for every factory.

In molding an assembly of the raw materials prepared as described above in a press machine, a suitable molding condition varies depending on the factors such as the composition of the resin raw material. Therefore, if the heat transfer capacity (rate of temperature rise: °C/sec) of the cushioning material used in the molding process does not meet the molding condition, variations in the material properties would occur between a sheet of the product in the central area of a stage and a sheet of the product near the hot plate in the same stage, and also between a central portion and a peripheral portion of a sheet of the product. This is caused by an inappropriate timing of raising the pressure during a heating process of the prepreg, in which the resin in the prepreg is reduced in its viscosity temporarily returning to a liquid state and thereafter the resin gradually hardens eventually forming a final product.

Thus, an inappropriate timing of press molding causes the temperature and pressure to go out of a permissible range for fluidizing the resin to bond the prepregs among themselves and also the prepreg and the copper foil, and to remove and absorb the air included in the resin. This is because, when the prepreg is pressurized while the viscosity of the resin is low, the resin is exceedingly fluidized leading to a problem that the thickness of the central part of the laminated board is increased while that of the peripheral part is reduced. Therefore, for example, when these laminated boards are laid up in several layers to form a multilayer printed wiring board, the thicknesses of the final products will be inconsistent.

On the contrary, when the prepreg is pressurized while the viscosity of the resin has been raised, the resin will not be sufficiently fluidized and therefore the air included in the resin would not be removed, which may cause a problem in the insulation properties and others of the final product.

Therefore, in every factory, it is believed that increasing the cushion volume is desirable for producing high quality products, but the increase of the cushion volume should be limited so as not to change the amount of heat transfer, i.e., the press molding condition in which the timing of pressurizing is crucial as described above.

Either in the case of a single layer press molding without laminate molding or in the case of a laminate molding of increased pages for mass production as described above, it is important to distribute heat uniformly over the entire product to obtain a high quality product. However, it is said that the difficulty in the manufacture increases in proportion to the square of the size of the product, because the larger the product size becomes, the greater the effect of the irregularities, deformations, thickness variations of the hot plates or the mirror plates becomes. Therefore, a cushioning material is desired which has a higher cushion volume than state of the art cushioning materials to uniformly distribute heat and pressure over the entire impregnated prepregs (in a B stage) for laminate molding.

Next, a manufacturing method of a multilayer printed wiring board is described referring to an example of a 4-layer printed wiring board.

First, a circuit pattern is printed on the copper foil on each surface of a laminate sheet manufactured by the above described method and then unnecessary copper foil is removed by a chemical agent to form a circuit pattern on each surface of the laminate sheet and this laminate sheet is used as the inner layer sheet. Then a 4-layer printed wiring board is manufactured in following steps: applying a prepreg similar to the laminate sheet on each side of the inner layer sheet; placing a copper foil on the prepreg of each side of the sheet; sandwiching the assembly with mirror plates; placing cushioning materials outside of them; and setting and pressing them in a press machine in a similar manner with the laminate sheet. But what a multilayer printed board is different from a laminate sheet is that its product size is smaller such as about 50 cm x 50 cm. The 4-layer printed wiring board is formed with holes of which the side surfaces are copper plated to interconnect the circuits on the inner layers and the outer layers. Finally, a circuit pattern is printed on the copper foil on the outer layer sheets and then the unnecessary copper foil is removed to form a circuit on each outer surface of the multilayer laminated board.

Although the product size in the manufacturing of a multilayer printed wiring board is small, it contains, unlike the laminates described above, inner layer sheets on which circuits are formed and therefore the absolute thickness of the material before press molding varies within a product depending on the presence or absence of the copper foil forming the circuits. Therefore, it is necessary to fluidize the resin sufficiently during press molding so that uniform thickness of the product is obtained. Thus, again a cushioning material is desired which provides an increased cushion volume without significantly changing its rate of temperature rise.

Furthermore, due to recent increase of highly-multilayered printed wiring boards used for the central processing units (CPUs) and/or the memory devices of super computers and high grade communications devices and/or high speed measuring devices such as satellite communications systems, and also due to predicted increase of multilayer boards in the future, there is even greater desire for cushioning materials with a higher cushion volume.

Recently various flat panel displays such as liquid crystal displays and electro-luminescence displays for televisions have been developed in place of CRT displays and, for the cushioning material used in the manufacturing steps of those displays such as bonding of display elements, a cushioning material to uniformly distribute heat and pressure is also desired as in the case of printed wiring boards. In the case of the manufacturing of flat panel displays, since the pressure of press molding is smaller unlike the case of the laminates for printed wiring boards and higher product precision is required, a single layer molding with a single-stage press is generally adopted instead of a multi-stage press molding. In these cases, variations in the heating condition during a press molding is not preferable and therefore there is also a need for an improved cushioning material which will uniformly distribute heat over the entire product.

Along with the progress of miniaturization and performance enhancement of semiconductor packages, a semiconductor package called a chip scale package, CSP, which has about the same size with a IC chip, has been growing, and there is a need for a cushioning material in a manufacturing process of CSPs as well which has an enhanced cushioning characteristics and uniformly distributes heat over the entire product. US-A-5,863,390 discloses a papermaking felt using poly(para-phenylene-benzoxazole) fiber. WO-A-0061508 discloses a covering material resistant to high temperatures and intended to be inserted between tools and plates of hot glass during glass heating, bending or tempering. EP-A-1084821 discloses a heat-resistant cushion material that includes one or more felt-like cushion layers produced by needle punching and a core member of the heat-resistant cushion material is composed of an elastic material that includes dispersed voids. High performance of poly-benzoxazole (PBO) fibers and various uses of the fibers are described in the literature (Research Disclosure, 354, pages 678-684, 01.01.1993).

### [Problems to be solved by the Invention]

Accordingly, it is an object of the present invention to solve the above described problems by providing a heat resistant cushioning material for press molding of which cushion volume can be increased without changing its rate of temperature rise thereby allowing uniform heat distribution.

### [Means for solving the Problems]

While conducting eager investigations to solve the above described problems, the inventers of the present invention have found that when heat resistant needled felt cushioning materials for press molding have the same density under a fixed condition, there is a correlation between the rate of temperature rise and the area weight of the cushioning material depending on the kind of the raw material. This indicates that although an increase of cushion volume can be achieved by increasing the area weight of the cushioning material, this will result in a decrease in its rate of temperature rise thereby failing to meet the current press molding conditions of the existing facilities and causing product defects such as poor resin flow. Although it is also possible to adapt the press molding condition to the cushioning material, this will lead to an excessive molding cycle time thus reducing the productivity. On the other hand, it is also found that to increase the rate of temperature rise, reduction of the area weight of the cushioning material is needed, but this will prohibit an uniform distribution of heat and pressure over the entire product thus causing product defects due to the lack of the cushion volume.

Accordingly, the inventors have come to a conclusion that there is a need for a material of which the rate of temperature rise is not decreased even when its area weight is increased. After conducting further investigations, the inventors have found a fiber material which has both high heat resistance and high heat conductivity eventually completing the present invention.

The aforementioned object is met by a use in according with claim 1 and dependent claims 2 - 7.

According to the present invention, it is possible to increase the cushion volume of the cushioning material without compromising its productivity by utilizing highly heat conductive fibers having a high rate of temperature rise which can not be achieved by conventional heat resistant fibers.

Moreover, it is also possible to uniformly distribute heat thereby enabling a volume production of high quality products by increasing the cushion volume of the cushioning material.

Furthermore, it is possible to increase the cushion volume without changing press molding conditions since the rate of temperature rise of the cushioning material does not change substantially even when its area weight is increased owing to the use of heat conductive fibers.

It is also possible to vary the rate of temperature rise of the cushioning material more widely than by a conventional method by mixing the heat conductive fibers with conventional heat resistant fibers, which makes it possible to balance the cushion volume and the rate of temperature rise of the cushioning material by adjusting the blending ratio and the area weight.

The heat resistant cushioning material for press molding used in the present invention is capable of uniformly distributing heat, which makes it possible to produce high quality products without variations in the quality over the entire product when used for the press molding of laminates for printed wiring boards, printed wiring boards, CSPs, and flat panel displays.

A degradation press, the measurement and calculation of a rate of temperature rise, and the measurement of a cushion volume are conducted as follows.

### 1. Degradation press

Test samples were subjected to a degradation press with a press molding machine at a temperature of 180°C and a pressure of 100 kg/m² for 1 hr to eliminate the effects of the initial density before evaluating the temperature rise characteristics and the cushion characteristics.

### 2. Temperature rise characteristics

### 1) Measurement method

Upon starting the test, the temperatures of the upper and lower hot plates of the press molding machine were set at 25°c and then the rate of temperature rise of the upper hot plate was set at 4.0 °c/min up to 200 °c. A prepared sample was provided between the upper and lower hot plates and pressed at a pressure of 20 kg/cm² and thereafter the temperature of the sample was measured at its surface of the unheated platen side (lower hot plate side).

### 2) Rate of temperature rise (°c/min)

A rate of temperature rise was determined by dividing a predetermined temperature range by the time which was needed for the temperature of the cushioning material measured at the contact surface with the lower hot plate in the above described condition to rise beyond the temperature range (in the present case, the temperature range of 50°C between 90°C to 140°C was divided by the time needed to rise through the temperature range).

### 3. Cushioning characteristics

### 1) Measurement method

The prepared samples were put into between the upper and lower hot plates of the press molding machine and the thickness of the prepared samples were measured while pressurizing them at 0 kg/cm² (contact pressure), 15 kg/cm², and 50 kg/cm².

### 2) Cushion volume (µm)

A cushion volume for a range from 15 kg/cm² to 50 kg/cm² was defined as the difference in the thicknesses of the sample when pressurized at 15 kg/cm² and 50 kg/cm².

### 4. Ultimate temperature (°C)

### 1) Measurement method

The measurement of an ultimate temperature was made simultaneously with the measurement of the rate of temperature rise.

The temperature of the sample put into between the hot plates of the press molding machine was measured at its surface of the unheated platen side (lower platen side).

### 2) Ultimate temperature (°C)

The ultimate temperature was determined as the temperature of the sample at the time one hour after its temperature reached 30°c.

### [Brief Description of the Drawings]

Fig. 1 shows an example of the press molding of a laminate.

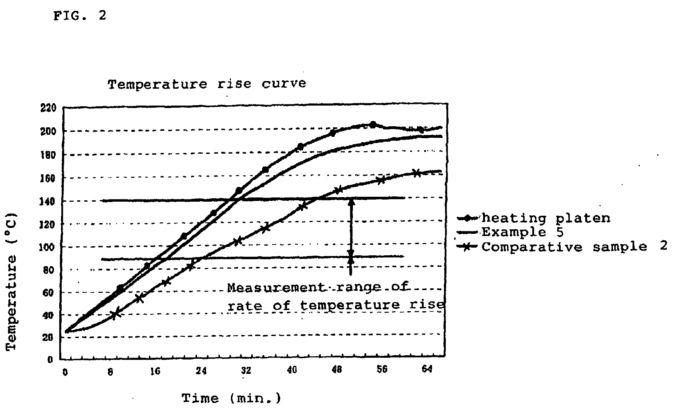

Fig. 2 shows temperature rise curves of the hot plate and the cushioning material during measurement of rate of temperature rise.

### [Description of the Symbols]

1 hot plate
2 heat resistant cushioning material
3 mirror plate
4 copper foil
5 prepreg

### [Embodiments]

The heat conductive fiber used for the heat resistant cushioning material for press molding according to the present invention may be of any type of fiber material as long as the following condition is satisfied; a product formed of 100% of the fiber material and having an area weight of 4000 g/m² has a rate of temperature rise of higher than 3.6 °C/min between 90 to 140°C. Examples of such fiber material include all types of aromatic polyester fibers, poly-para-phenylene benzobisoxazole(PBO) fibers, stainless steel fibers and others. Particularly, such a fiber material is preferable that, for example, when it is formed into a product with an area weight of 2000 g/m², its rate of temperature rise between 90 to 140°C is 3.8 to 4.0 °C/min and when formed into a product with an area weight of 4000 g/m² its rate of temperature rise is 3.6 to 3.8 °C/min, since increasing the area weight of the product twice would not change its rate of temperature rise significantly thus making it possible to increase the cushion volume without changing the press molding condition. An example of such fiber material is poly-para-phenylene benzobisoxazole(PBO) fiber, which is particularly preferable since it has high heat resistance and small dimensional variations during use in addition to good heat conductivity.

The material used for the base material and the batt fiber of the heat resistant cushioning material for press molding of the present invention may be of any type of fiber material as long as the following conditions are met; it has enough heat resistance for longer period uses under high temperature and high pressure press molding conditions (for example, under press molding conditions for glass epoxy laminates: temperature 180 to 210°C, pressure 30 to 50 kg/cm²; for paper-phenol laminates: temperature 160 to 190°C , pressure 80 to 120 kg/cm²; for liquid crystal panels: temperature 160 to 180°C, pressure 3 to 5 kg/cm²). Examples of such fiber include meta-aromatic polyamide fiber (CONEX (trade name of Teijin) and NOMEX (trade name of Dupont)), para-aromatic polyamide fiber with poly-para-phenylene telephtalamides as the principal component (KEVLAR (trade name of Dupont), TECHNOLA (trade name of Teijin)), and PPS fiber (TORCON (trade name of Toray)). For example, by using a fiber material of which the rate of temperature rise between 90 to 140°C is 2.5 to 3.1 °C/min when formed into a product with an area weight of 2000 g/m², and 1.0 to 1.8 °C/min when formed into a product with an area weight of 4000 g/m², it is possible to adjust the rate of temperature rise by changing the blend ratio of the fiber material since its rate of temperature rise is low compared to the above described heat conductive fibers. Out of those fibers, aromatic polyamide fibers are preferable in the view point of heat resistance, and particularly meta-aromatic polyamide fibers are preferable from the viewpoint of the adjustment of the rate of temperature rise, though the para-aromatic or metha-aromatic polyamides should be chosen appropriately depending on the object of use. The fiber materials used for the base material and the batt fiber may be either of the same kind or of a different kind.

The blend ratio of heat conductive fibers in the cushioning material may be varied from 20 to 100 wt% to change its rate of temperature rise to increase the productivity and improve the quality (blending unevenness). The heat resistant cushioning material for press molding of the present invention is manufactured by laminating one or more layers of batt fiber made of one or more of the above described fibers as the principal base material on one side or both sides of a single layer woven fabric or several layers of laminated fabric and then by needling the base material and the batt fiber to integrate them.

Specifically, a pre-needle material is prepared by placing batt fiber with an area weight of 50 to 200 g/m², preferably 75 to 150 g/m² on a sheet of woven fabric which is the base material with an area weight of 30 to 300 g/m², preferably 50 to 150 g/m² and then needling the batt fiber with the base material. 2 to 15 thicknesses of this pre-needled material are made entangled each other through needling, and the number of entangled thicknesses is preferably 3 to 6. When a cushioning material thus manufactured by integrating the base material and the batt fibers through needling has an area weight of 500 to 7000 g/m², preferably 1500 to 3000 g/m² and a thickness of 1 to 30 mm, preferably 2 to 15 mm, it will have satisfactory properties as the cushioning material.

There is a special example in which instead of blending fibers of a low rate of temperature rise with the fibers of a high rate of temperature rise, fibers of a low rate of temperature rise are placed in the center and fibers of a high rate of temperature rise are laid up on one side or both sides of the fibers in the center. In this example, by increasing the area weight of fibers of a low rate of temperature rise, the temperature rise characteristics and cushioning characteristics are made more uniform and thereby the heat flow from the cushioning material to the mirror plate (product side) is smoothed. In principle, a fiber layer of a high rate of temperature rise is needed on the side in contact with mirror plate. However it is not always the case that the same surface faces the outside, therefore a fiber layer of a high rate of temperature rise is formed on each side of the cushioning material. In this configuration, the productivity is inferior to the above described blended batt fiber configuration. The heat resistant cushioning material for press molding of the present invention has a good cushion characteristics, distributes heat uniformly and effectively, and allows the adjustment of temperature, which makes it particularly preferable for the cushioning material used in the manufacture of laminates for printed wiring boards, printed wiring boards, CSPs, and flat panel displays in which the timings of heating and pressuring have a great influence on the product quality.

### [Examples]

The heat resistant cushioning materials for press molding of the present invention will be further described referring to examples which, however, will not impose any limitation on the present invention.

### Example 1

Four layers of batt fibers each having an area weight of 100 g/m² and comprised of 50 % PBO and 50% KEVLAR blended fibers were placed on and needled to a sheet of base fabric having an area weight of 100 g/m² and comprised of spun yarns of PBO fiber to form a pre-needle with an area weight of 500 g/m², which was further needled in four layers to form an integrated needled felt cushioning material for press molding with an area weight of 2000 g/m² and a thickness of 6mm:

### Example 2

Three layers of base fabrics each having an area weight of 100 g/m² and comprised of spun yarns of PBO fiber were laid up to form a base sheet and batt fiber comprised of 70% PBO and 30% Kevlar blended fibers was placed on and needled to each side of the base sheet forming an integrated needled felt cushioning material for press molding with an area weight of 2000 g/m² and a thickness of 6 mm.

### Example 3

Four layers of batt fibers each having an area weight of 100 g/m² and comprised of 50 % PBO and 50% CONEX blended fibers were placed on and needled to a sheet of base fabric having an area weight of 100 g/m² and comprised of spun yarns of PBO fiber forming a pre-needle with an area weight of 500 g/m², which was further needled in four layers to form an integrated needled felt cushioning material for press molding with an area weight of 2000 g/m² and a thickness of 6mm.

### Example 4

Three sheets of base fabrics each having an area weight of 100 g/m² and comprised of spun yarns of PBO fiber were laid up to form a base sheet and batt fiber comprised of 70% PBO and 30% CONEX blended fibers were placed on and needled to each side of the base sheet to form an integrated needled felt cushioning material for press molding with an area weight of 2000 g/m² and a thickness of 6 mm.

### Example 5

Four layers of batt fibers each having an area weight of 100 g/m² and comprised of 100 % PBO fibers were placed on and needled to a sheet of base fabric having an area weight of 100 g/m² and comprised of spun yarns of PBO fiber forming a pre-needle with an area weight of 500 g/m², which was further needled in four layers to form an integrated needled felt cushioning material for press molding with an area weight of 2000 g/m² and a thickness of 6mm.

### Example 6

Four layers of batt fibers each having an area weight of 100 g/m² and comprised of 50 % PBO and 50% Kevlar blended fibers were placed on and needled to a sheet of base fabric having an area weight of 100 g/m² comprised of spun yarns of PBO fiber forming a pre-needle with an area weight of 500 g/m², which was further needled in eight layers to form an integrated needled felt cushioning material for press molding with an area weight of 4000 g/m² and a thickness of 13 mm.

### Example 7

Four layers of batt fibers each having an area weight of 100 g/m² and comprised of 70 % PBO and 30% Kevlar blended fibers were placed on and needled to a sheet of base fabric having an area weight of 100 g/m² and comprised of spun yarns of PBO fiber forming a pre-needle with an area weight of 500 g/m², which was further needled in eight layers to form an integrated needled felt cushioning material for press molding with an area weight of 4000 g/m² and a thickness of 13 mm.

### Example 8

Four layers of batt fibers each having an area weight of 100 g/m² and comprised of 50 % PBO and 50% CONEX blended fibers were placed on and needled to a sheet of base fabric having an area weight of 100 g/m² and comprised of spun yarns of PBO fiber forming a pre-needle with an area weight of 500 g/m², which was further needled in eight layers to form an integrated needled felt cushioning material for press molding with an area weight of 40.00 g/m² and a thickness of 13 mm.

### Example 9

Four layers of batt fibers each having an area weight of 100 g/m² comprised of 70 % PBO and 30% CONEX blended fibers were placed on and needled to a sheet of base fabric having an area weight of 100 g/m² and comprised of spun yarns of PBO fiber forming a pre-needle with an area weight of 500 g/m², which was further needled in eight layers to form an integrated needled felt cushioning material for press molding with an area weight of 4000 g/m² and a thickness of 13 mm.

### Example 10

Four layers of batt fibers each having an area weight of 100 g/m² and comprised of PBO fibers were placed on and needled to a sheet of base fabric having an area weight of 100 g/m² and comprised of spun yarns of PBO fiber forming a pre-needle with an area weight of 500 g/m², which was further needled in eight layers to form an integrated needled felt cushioning material for press molding with an area weight of 4000 g/m² and a thickness of 13 mm.

### Example 11

Four layers of batt fibers each having an area weight of 100 g/m² and comprised of PBO fibers was placed on and needled to a sheet of base fabric having an area weight of 100 g/m² and comprised of spun yarns of PBO fiber forming a pre-needle with an area weight of 500 g/m², which was further needled in fourteen layers to form an integrated needled felt cushioning material for press molding with an area weight of 7000 g/m² and a thickness of 23 mm.

### Example 12

Three layers of base fabrics each having an area weight of 100 g/m² and comprised of spun yarns of PBO fiber were laid up to form a base sheet and batt fiber having an area weight of 650 g/m² and comprised of 100 % Kevlar was needled to each side of the base sheet, and batt fiber having an area weight of 200 g/m² and comprised of 100% PBO was further needled to each side of the needled Kevlar layer to form an integrated needled felt cushioning material for press molding with an area weight of 2000 g/m² and a thickness of 6 mm.

### Example 13

Three layers of base fabrics each having an area weight of 100 g/m² and comprised of spun yarns of PBO fiber were laid up to form a base sheet and batt fiber having an area weight of 650 g/m² and comprised of 100 % CONEX was needled to each side of the base sheet, and batt fiber with an area weight of 200 g/m² and comprised of 100% PBO was further needled to each side of the needled CONEX layer to form an integrated needled felt cushioning material for press molding with an area weight of 2000 g/m² and a thickness of 6 mm.

### Comparative sample 1

Three layers of base fabrics each having an area weight of 100 g/m² and comprised of spun yarns of Kevlar were laid up to form a base sheet and batt fiber comprised of 100% Kevlar was needled to each side of the sheet to form an integrated needled felt cushioning material for press molding with an area weight of 2000 g/m² and a thickness of 6 mm.

### Comparative sample 2

Three layers of base fabrics each having an area weight of 100 g/m² and comprised of spun yarns of CONEX were laid up to form a base sheet and batt fiber comprised of 100% CONEX was needled to each side of the base sheet to form an integrated needled felt cushioning material for press molding with an area weight of 2000 g/m² and a thickness of 6 mm.

### Comparative sample 3

Four layers of batt fibers each having an area weight of 100 g/m² and comprised of Kevlar were placed on and needled to a sheet of base fabric having an area weight of 100 g/m² and comprised of spun yarns of Kevlar forming a pre-needle with an area weight of 500 g/m², which was further needled in eight layers to form an integrated needled felt cushioning material for press molding with an area weight of 4000 g/m² and a thickness of 13 mm.

### Comparative sample 4

Four layers of batt fibers each having an area weight of 100 g/m² and comprised of CONEX were placed on and needled to a sheet of base fabric having an area weight of 100 g/m² and comprised of spun yarn of CONEX forming a pre-needle with an area weight of 500 g/m², which was further needled in eight layers to form an integrated needled felt cushioning material for press molding with an area weight of 4000 g/m² and a thickness of 13 mm.

### Comparative sample 5

Batt fiber with a total area weight of 900 g/m² comprised of 100% CONEX was placed on and needled to each side of a base fabric having an area weight of 100 g/m² and comprised of spun yarns of CONEX to form an integrated needled felt cushioning material for press molding with an area weight of 1000 g/m² and a thickness of 3.3 mm.

### Rate of temperature rise

The rate of temperature rise and the ultimate temperature measured between 90 to 140°C in the above described condition are shown in Table 1 for each heat resistant cushioning material for press molding. Example 11 and comparative samples 1 and 5 are comprised of PBO, KEVLAR, and CONEX fibers respectively and configured to have about same rate of temperature rise.

### [Table 1]

**Table 1. Comparison of rate of temperature rise**

| | Area weight of product (g/m²) | Area weight of base material (g/m²) | Base material | Total weight of batt fiber (g/m²) | Batt fiber material and Blend ratio | Ratio of PBO (Total) | Rate of temp. rise 90 to 140°C | Ultimate temp. (°C) |
|---|---|---|---|---|---|---|---|---|
| Example 1 | 2000 | 100*4 | P=100% | 1600 | P:K=50%:50% | 60% | 3.5 | 182.0 |
| Example 2 | 2000 | 100*3 | P-100% | 1700 | P:K=70%:30% | 75% | 3.7 | 185.0 |
| Example 3 | 2000 | 100*4 | P=100% | 1600 | P:C=50%:50% | 60% | 3.3 | 178.0 |
| Example 4 | 2000 | 100*3 | P=100% | 1700 | P:C=70%:30% | 75% | 3.6 | 184.0 |
| Example 5 | 2000 | 100*4 | P=100% | 1600 | P=100% | 100% | 3.9 | 192.0 |
| Example 6 | 4000 | 100*8 | P=100% | 3200 | P:K=50%:50% | 60% | 2.9 | 175.0 |
| Example 7 | 4000 | 100*8 | P=100% | 3200 | P:K=70%:30% | 76% | 3.2 | 179.0 |
| Example 8 | 4000 | 100*8 | P=100% | 3200 | P:C=50%:50% | 60% | 2.8 | 175.0 |
| Example 9 | 4000 | 100*8 | P=100% | 3200 | P:C=70%:50% | 76% | 3.1 | 180.0 |
| Example 10 | 4000 | 100*8 | P=100% | 3200 | P=100% | 100% | 3.7 | 183.0 |
| Example 11 | 7000 | 100*14 | P=100% | 5600 | P=100% | 100% | 3.0 | 178.0 |
| Example 12 | 2000 | 100*3 | P=100% | 1700 | outer layer P=100%, 400g/m² inner layer K=100%,1300g/m² | 35% | 3.3 | 179.0 |
| Example 13 | 2000 | 100*3 | P=100% | 1700 | outer layer P=100%,400g/m² inner layer C=100%,1300g/m² | 35% | 2.9 | 175.0 |
| Com. Sample 1 | 2000 | 100*3 | K=100% | 1700 | K=100% | 0% | 3.1 | 175.0 |
| Com. Sample 2 | 2000 | 100*3 | C=100% | 1700 | C=100% | 0% | 2.5 | 163.0 |
| Com. Sample 3 | 4000 | 100*8 | K=100% | 3200 | K=100% | 0% | 1.8 | 153.0 |
| Com. Sample 4 | 4000 | 100*8 | C=100% | 3200 | C=100% | 0% | 1.5 | 145.0 |
| Com. Sample 5 | 1000 | 100*1 | C=100% | 900 | C=100% | 0% | 3.0 | 178.0 |

| | | | | | | | | |
|---|---|---|---|---|---|---|---|---|
| P:PBO K:KEVLAR C:CONEX | | | | | | | | |

Comparing examples 5 and 10 both comprised of POB fibers alone indicates that the change in the rate of temperature rise due to the change in the area weight is small, thus showing preferable characteristics of these examples. It was also shown that the rate of temperature rise can be changed by changing the blending ratio of PBO fibers.

Example 11, comparative sample 1, and comparable sample 5 were respectively comprised of a single kind of fibers: PBO, Kevlar, and CONEX fibers respectively and configured to have a rate of temperature rise of about 3.0 °C/min. The result indicated that the area weight of the sample of each fiber significantly differs each other; they are 7000 g/m² for PBO, 2000 g/m² for Kevlar, and 1000 g/m² for CONEX.

### [Cushioning characteristics]

Heat resistant cushioning materials of examples 5, 10, and 11 formed of PBO fibers (area weight is 2000 g/m², 4000 g/m², and 7000 g/m² respectively), comparative samples 1 and 3 formed of Kevlar fibers (area weight is 2000 g/m² and 4000 g/m² respectively), and comparative samples 2, 4, and 5 formed of CONEX fibers(area weight is 2000 g/m², 4000 g/m², and 1000 g/m² respectively) were pressurized at 0 to 50 kg/cm² at 180°C and 250°C, and the thickness change (*µ*m) of the cushioning materials between 15 kg/cm² and 50 kg/cm² were measured as the cushion volume; the results are shown in Table 2.

### [Table 2]

**Table 2 Cushion volume Degradation condition: temperature 180°C, pressure 100kg/cm², time 1 hr**

| | measurement temperature | material-area weight (g/m²) | Cushion volume (*µ*m) 15 to 50 kg/cm² after 1 hr degradation | rate of temperature rise 90 to 140°C (°C/min) |
|---|---|---|---|---|
| Example 5 | 180°C | P-2000 | 101 | 3.9 |
| Example 10 | | P-4000 | 178 | 3.7 |
| Example 11 | | P-7000 | 356 | 3.0 |
| Comparative sample 1 | | K-2000 | 137 | 3.1 |
| Comparative sample 3 | | K-4000 | 272 | 1.8 |
| Comparative sample 2 | | C-2000 | 175 | 2.5 |
| Comparative sample 4 | | C-4000 | 325 | 1.5 |
| Comparative sample 5 | | C-1000 | 80 | 3.0 |
| Example 5 | 250°C | P-2000 | 79 | 3.9 |
| Example 10 | | P-4000 | 147 | 3.7 |
| Example 11 | | P-7000 | 285 | 3.0 |
| Comparative sample 1 | | K-2000 | 66 | 3.1 |
| Comparative sample 3 | | K-4000 | 87 | 1.8 |
| Comparative sample 2 | | C-2000 | 31 | 2.5 |
| Comparative sample 4 | | C-4000 | 48 | 1.5 |
| Comparative sample 5 | | C-1000 | 16 | 3.0 |

The thickness changes (cushion volume) of heat resistant cushioning materials formed of POB fibers, Kevlar fibers and CONEX fibers were compared for the same area weight under pressures from 15 kg/cm² to 50 kg/cm², which are considered to be important pressures when used in manufacturing facilities for glass epoxy laminates and multi-layer laminates. The results indicate that the cushion volume of POB is smaller than that of CONEX by 150 *µ*m and also smaller than that of Kevlar by 100 *µ*m for the area weight of 4000 g/m² at a measurement temperature of 180°C, but at a measurement temperature of 250°C, the cushion volume of POB fibers is about three times greater than that of CONEX and 1.7 times greater than that of Kevlar. Moreover, there is no significant decrease in the cushion volume of PBO fibers when measurement temperature is raised from 180°C to 250°C (Example 10, Comparative sample 3, Comparative sample 4).

Comparing the cushion volume (Example 11, Comparative samples 1 and 5) at a rate of temperature rise of about 3.0°C /min, the cushion volume of POB fibers is about 4.5 times greater than that of CONEX and about 2.5 times greater than that of Kevlar at 180°C. Moreover, at a measurement temperature of 250°C, the cushion volume of POB was 285 *µ*m and was about 18 times greater than that of CONEX and about 4 times greater than that of Kevlar.

## Claims

1. A use of a heat resistant cushioning material for press molding in the manufacture of laminates for printed wiring boards, printed wiring boards, chip scale packages, and flat panel displays, said cushioning material being formed by laminating one or more layers of batt fiber onto one side or both sides of a base fabric and integrating said batt fiber and said base fabric by needling, said batt fiber consisting of one or more kinds of fibers being the same as or different from those used for the base fabric, **characterised in that** said cushioning material comprises 20 to 100 wt% of heat conductive fibers which have a rate of temperature rise of not smaller than 3.6 °C /min in a range of 90°C to 140°C in a form configured to have an area weight of 4000 g/m².

2. The use according to claim 1, **characterized in that** said heat conductive fibers have a rate of temperature rise of 3.8 to 4.0 °C/min in a range of 90°C to 140°C in a form configured to have an area weight of 2000 g/m² and have a rate of temperature rise of 3.6 to 3.8 °C/min in the same temperature range in a form configured to have an area weight of a 4000 g/m².

3. The use according to claim 1 or 2, **characterized in that** said heat conductive fibers are poly-para-phenylene benzobisoxazole fibers.

4. The use according to any one of claims 1 to 3, **characterized in that** said heat resistant cushioning material further comprises fibers which have a rate of temperature rise of 2.5 to 3.1 °C/min in a range of 90°C to 140°C in a form configured to have an area weight of 2000 g/m² and have a rate of temperature rise of 1.0 to 1.8 °C/min in the same temperature range in a form configured to have an area weight of 4000 g/m².

5. The use according to any one of claims 1 to 4, **characterized in that** said heat resistant cushioning material further comprises aromatic polyamide fibers.

6. The use according to claim 5, **characterized in that** said aromatic polyamide fiber comprises metha-aromatic polyamide fibers and/or para-aromatic polyamide fibers.

7. The use according to any one of claims 1 to 6, **characterized in that** said printed wiring boards are a multilayer printed wiring board.

## Patentansprüche

1. Verwendung eines hitzebeständigen Dämpfungsmaterials zum Pressformen bei der Herstellung von Laminaten für gedruckte Leiterplatten, gedruckten Leiterplatten, Verpackungen im Chip-Maßstab (chip scale packages) und Flachbildschirmen, wobei das Dämpfungsmaterial durch Laminieren einer oder mehrerer Schichten einer Fasermatte auf eine Seite oder auf beide Seiten eines Basisgewebes und durch Verflechten der Fasermatte und des Basisgewebes durch Nähen gebildet wird, wobei die Fasermatte aus einer oder mehreren Arten von Fasern besteht, welche dieselben oder von jenen verschieden sein können, die für das Basisgewebe verwendet werden, **dadurch gekennzeichnet, dass** das Dämpfungsmaterial 20 bis 100 Gew.-% wärmeleitende Fasern umfasst, welche eine Geschwindigkeit des Temperaturanstiegs von nicht weniger als 3,6 °C/Min. in einem Bereich von 90 °C bis 140 °C aufweisen, bei einer Form, die so aufgebaut ist, dass sie ein Flächengewicht von 4.000 g/m² besitzt.

2. Verwendung nach Anspruch 1, **dadurch gekennzeichnet, dass** die wärmeleitenden Fasern eine Geschwindigkeit des Temperaturanstiegs von 3,8 bis 4,0 °C/Min. in einem Bereich von 90 °C bis 140 °C aufweisen, bei einer Form, die so aufgebaut ist, dass sie ein Flächengewicht von 2.000 g/m² besitzt, und eine Geschwindigkeit des Temperaturanstiegs von 3,6 bis 3,8 °C/Min. im selben Temperaturbereich aufweisen, bei einer Form, die so aufgebaut ist, dass sie ein Flächengewicht von 4.000 g/m² besitzt.

3. Verwendung nach Anspruch 1 oder 2, **dadurch gekennzeichnet, dass** die wärmeleitenden Fasern poly-para-Phenylenbenzobisoxazol-Fasern sind.

4. Verwendung nach einem der Ansprüche 1 bis 3, **dadurch gekennzeichnet, dass** das hitzebeständige Dämpfungsmaterial ferner Fasern umfasst, welche eine Geschwindigkeit des Temperaturanstiegs von 2,5 bis 3,1 °C/Min. in einem Bereich von 90 °C bis 140 °C aufweisen, bei einer Form, die so aufgebaut ist, dass sie ein Flächengewicht von 2000 g/m² besitzt, und eine Geschwindigkeit des Temperaturanstiegs von 1,0 bis 1,8 °C/Min, im selben Temperaturbereich aufweisen, bei einer Form, die so aufgebaut ist, dass sie ein Flächengewicht von 4000 g/m² besitzt.

5. Verwendung nach einem der Ansprüche 1 bis 4, **dadurch gekennzeichnet, dass** das hitzebeständige Dämpfungsmaterial ferner aromatische Polyamidfasern umfasst.

6. Verwendung nach Anspruch 5, **dadurch gekennzeichnet, dass** die aromatische Polyamidfaser meta-aromatische Polyamidfasern und/oder para-aromatische Polyamidfasern umfasst.

7. Verwendung nach einem der Ansprüche 1 bis 6, **dadurch gekennzeichnet, dass** die gedruckten Leiterplatten gedruckte Leiterplatten aus vielen Schichten (multi layer printed wiring boards) sind.

## Revendications

1. Utilisation d'un matériau de rembourrage résistant à la chaleur pour un moulage à la presse pour la fabrication de laminés pour des cartes de câblage imprimées, de cartes de câblage imprimées, de boîtiers-puce, et d'affichages à écran plat, ledit matériau de rembourrage étant formé en laminant une ou plusieurs couches de fibre de natte sur un côté ou les deux côtés d'un tissu de base et en intégrant ladite fibre de natte et ledit tissu de base par aiguilletage, ladite fibre de natte étant constituée d'un ou plusieurs types de fibres qui sont les mêmes que celles utilisées pour le tissu de base, ou différentes de celles-ci, **caractérisée en ce que** ledit matériau de rembourrage comporte 20 à 100 % en poids de fibres conduisant la chaleur qui ont une vitesse d'augmentation de température qui n'est pas inférieure à 3,6°C/min dans une plage de 90°C à 140°C sous une forme configurée pour avoir un poids superficiel de 4 000 g/m².

2. Utilisation selon la revendication 1, **caractérisée en ce que** lesdites fibres conduisant la chaleur ont une vitesse d'augmentation de température de 3,8 à 4,0°C/min dans une plage de 90°C à 140°C sous une forme configurée pour avoir un poids superficiel de 2 000 g/m² et ont une vitesse d'augmentation de température de 3,6 à 3,8°C/min dans la même plage de température sous une forme configurée pour avoir un poids superficiel de 4 000 g/m².

3. Utilisation selon la revendication 1 ou 2, **caractérisée en ce que** lesdites fibres conduisant la chaleur sont des fibres de benzobisoxazole de poly-para-phénylène.

4. Utilisation selon l'une quelconque des revendications 1 à 3, **caractérisée en ce que** ledit matériau de rembourrage résistant à la chaleur comporte de plus des fibres qui ont une vitesse d'augmentation de température de 2,5 à 3,1°C/min dans une plage de 90°C à 140°C sous une forme configurée pour avoir un poids superficiel de 2 000 g/m² et ont une vitesse d'augmentation de température de 1,0 à 1,8°C/min dans la même plage de température sous une forme configurée pour avoir un poids superficiel de 4 000 g/m².

5. Utilisation selon l'une quelconque des revendications 1 à 4, **caractérisée en ce que** ledit matériau de rembourrage résistant à la chaleur comporte de plus des fibres de polyamide aromatique.

6. Utilisation selon la revendication 5, **caractérisée en ce que** ladite fibre de polyamide aromatique comporte des fibres de polyamide métha-aromatique et/ou des fibres de polyamide para-aromatique.

7. Utilisation selon l'une quelconque des revendications 1 à 6, **caractérisée en ce que** lesdites cartes de câblage imprimées sont une carte de câblage imprimée multicouche.
